(19) Europäisches Patentamt
European Patent Office
Office européen des brevets

(11) **EP 2 768 019 A2**

## (12) EUROPEAN PATENT APPLICATION

(43) Date of publication:
**20.08.2014 Bulletin 2014/34**

(51) Int Cl.:
***H01L 23/49*** *(2006.01)*     ***C22C 9/00*** *(2006.01)*

(21) Application number: **13002674.3**

(22) Date of filing: **15.07.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **15.02.2013 EP 13000801
03.05.2013 EP 13002359**

(71) Applicant: **Heraeus Materials Singapore Pte. Ltd.
569871 Singapore (SG)**

(72) Inventors:
• **Sarangapani, Murali
760363 Singapore (SG)**

• **Yeung, Ping Ha
457266 Singapore (SG)**
• **Milke, Eugen
60322 Frankfurt (DE)**

(74) Representative: **Brand, Normen
Heraeus Holding GmbH
Schutzrechte
Heraeusstraße 12-14
63450 Hanau (DE)**

Remarks:
Missing drawings filed in accordance with Rule 56(3) EPC.

## (54) Copper bond wire and method of making the same

(57)     The invention is related to a bonding wire, comprising a core with a surface, wherein the core comprises copper as a main component, wherein the core comprises copper as a main component, wherein an average size of crystal grains in the core is between 2.5 $\mu$m and 30 $\mu$m, and wherein a yield strength of the bonding wire is less than 120 MPa.

**Description**

The invention is related to a bonding wire, comprising a core with a surface, wherein the core comprises copper as a main component, wherein an average size of crystal grains in the core is between 2.5 $\mu$m and 30 $\mu$m, and wherein a yield strength of the bonding wire is less than 120 MPa.

The invention further relates to a module, comprising a first bond pad, a second bond pad and a wire according to the invention, wherein the inventive wire is connected to at least one of the bond pads by means of ball-bonding.

The invention further relates to a method for manufacturing a wire according to the invention.

Bonding wires are used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of the housing. While bonding wires were made from gold in the beginning, nowadays less expensive materials are used such as copper. While copper wire provides very good electric and thermal conductivity, ball-bonding as well as wedge-bonding of copper wire has its challenges. Moreover, copper wires are susceptible to oxidation.

With respect to wire geometry, most common are bonding wires of circular cross-section and bonding ribbons which have a more or less rectangular cross-section. Both types of wire geometries have their advantages making them useful for specific applications. Thus, both types of geometry have their share in the market. For example, bonding ribbons have a larger contact area for a given cross-sectional area. However, bending of the ribbons is limited and orientation of the ribbon must be observed when bonding in order to arrive at acceptable electrical contact between the ribbon and the element to which it is bonded. Turning to bonding wires, these are more flexible to bending. However, bonding involves welding and larger deformation of the wire in the bonding process, which can cause harm or even destroy the bond pad and underlying electric structures of the element, which is bonded thereto.

For the present invention, the term bonding wire comprises all shapes of cross-sections and all usual wire diameters, though bonding wires with circular cross-section and thin diameters are preferred.

Some recent developments were directed to bonding wires having a copper core. As core material, copper is chosen because of high electric conductivity. Different dopants to the copper material have been searched for in order to optimize the bonding proper-ties. For example, US 7,952,028 B2 describes several different copper-based test wires with a large number of different dopants and concentrations. Nevertheless, there is an ongoing need for further improving bonding wire technology with regard to the bonding wire itself and the bonding processes.

Accordingly, it is an object of the invention to provide improved bonding wires.

Thus, it is another object of the invention to provide a bonding wire, which has good processing properties and which has no specific needs when interconnecting, thus saving costs.

It is also an object of the invention to provide a bonding wire which has excellent electrical and thermal conductivity.

It is a further object of the invention to provide a bonding wire which exhibits an improved reliability.

It is a further object of the invention to provide a bonding wire which exhibits excellent bondability.

It is another object of the invention to provide a bonding wire which shows an improved bondability with respect to a ball bonding.

It is another object of the invention to provide a bonding wire which shows an improved bondability with respect to a first bonding being a ball bonding, whilst the bonding performance for a second bonding being a wedge bonding is at least sufficient.

It is another object of the invention to provide a bonding wire which shows an increased softness of the wire core before bonding.

It is another object of the invention to provide a bonding wire which has improved resistance to corrosion and/or oxidation.

It is another object to provide a system for bonding an electronic device or module, to be used with standard chip and bonding technology, which system or module shows reduced failure rate at least with respect to a first bonding.

It is another object to provide a method for manufacturing an inventive bonding wire, the method basically showing no increase in manufacturing costs compared with known methods.

Surprisingly, wires of the present invention have been found to solve at least one of the objects mentioned above. Further, a process for manufacturing these wires has been found which overcomes at least one of the challenges of manufacturing wires. Further, systems and modules comprising the wires of the invention were found to be more reliable at the interface between the wire according to the invention and other electrical elements, e.g., the printed circuit board, the pad/pin etc.

A contribution to the solution of at least one of the above objects is provided by the subject matters of the category-forming claims, whereby the dependent sub-claims of the category-forming independent claims representing preferred aspects of the invention, the subject matter of which likewise makes a contribution to solving at least one of the objects mentioned above.

A first aspect of the invention is a bonding wire, comprising:

> a core with a surface,
> wherein the core comprises copper as a main component,
> wherein an average size of crystal grains in the core is between 2.5 $\mu$m and 30 $\mu$m, and
> wherein a yield strength of the bonding wire is less than 120 MPa.

Such wire according to the invention has an optimized crystal structure with respect to its mechanical and bonding properties.

If no other specific definition is provided, all contents or shares of components are presently given as shares in weight. In particular, shares given in percent are understood as weight-%, and shares given in ppm (parts per million) are understood as weight-ppm.

A core of the wire is defined as a homogenous region of bulk material below a surface. As any bulk material basically has a surface region with different properties to some extent, the properties of the core of the wire are understood as properties of this bulk material region. The surface of the bulk material region can differ in terms of morphology, composition (e.g. oxygen content) or other features. The surface can be an outer surface of the inventive wire in preferred embodiments. In further embodiments, the surface of the wire core can be provided as an interface region between the wire core and a coating layer superimposed on the wire core.

Concerning the average grain size of the crystal grains, the size of the grains is determined by using a standard metallographic technique. A sample of the wires core is cross-sectioned and then etched. In the present case, a solution of 2g $FeCl_3$ and 6 ml concentrated HCl in 200 ml DI-water was used for the etching. The grain sizes are measured and calculated by the line intercept principles. A common definition used herein is that the size of a grain is defined as the longest of all sections of straight lines passing through the grain.

Generally preferred, a ratio between a diameter of the wire core and the average grain size is between 2.5 and 5. Even more preferred, the ratio is between 2.5 and 4. This allows for an optimization of the wire properties throughout the range of different diameters of the wire. In particular, the preferred ratios can be beneficial to the properties of thin wires.

Under consideration of the respective wire diameter, a specifically optimized selection of advantageous average grain sizes is achieved as follows:

> a diameter of the wire core is between 15 $\mu$m and 28 $\mu$m and the average grain size is between 2.5 $\mu$m and 6 $\mu$m; or
> a diameter of the wire core is between 28 $\mu$m and 38 $\mu$m and the average grain size is between 3 $\mu$m and 10 $\mu$m; or
> a diameter of the wire core is between 38 $\mu$m and 50 $\mu$m and the average grain size is between 7 $\mu$m and 15 $\mu$m; or
> a diameter of the wire core is between 50 $\mu$m and 80 $\mu$m and the average grain size is between 10 $\mu$m and 30 $\mu$m.

The wire is a bonding wire in particular for bonding in microelectronics. The wire is preferably a one-piece object.

A component is a "main component" if the share of this component exceeds all further components of a referenced material. Preferably, a main component comprises at least 50% of the total weight of the material.

For the definition of a yield strength, reference is made to the common understanding. The "yield strength" of a material is defined in engineering and materials science as the stress at which a material begins to deform plastically. Prior to the beginning of plastic deformation, the material will deform elastically and will return to its original shape when the applied stress is removed.

Generally preferred, the yield strength of a bonding wire of the invention is less than 110 MPa and more preferred less than 90 MPa. Most preferred, the yield strength is not more than 80 MPa. As a general rule, it is advantageous for the bonding properties of the inventive wire if the yield strength is reduced.

A lower limit of the yield strength of an inventive wire is preferably more than 50 MPa and most preferably more than 65 MPa. This particularly results in preferred and advantageous ranges for the yield strengths of an inventive bonding wire. A bonding wire according to the invention preferably has a yield strength in one or more of the ranges 50..120 MPa, 50..110 MPa, 65..110 MPa, 65..90 MPa or 65..80 MPa.

In a preferred embodiment of the invention, a Young's modulus of the wire is less than 100 GPa. More preferably, the Young's modulus is less than 95 GPa. The optimization of the wire with respect to its Young's modulus is beneficial for its mechanical properties and also for its behaviour in a bonding process.

A lower limit of the Young's modulus can be accounted for in order to prevent disadvantageous effects. Is has turned out that the Young's modulus of an optimized wire should not be below 75 GPa, preferably not below 80 GPa. A bonding wire according to the invention preferably has a Young's modulus in one or more of the ranges 75..100 GPa, 75..95 GPa or 80..95 GPa.

For the definition of Young's modulus, reference is made to the common understanding. Young's modulus, also known as the tensile modulus or elastic modulus, is a measure of the stiffness of an elastic material and is a quantity used to characterize materials. It is defined as the ratio of the stress along an axis over the strain along that axis in the range of stress in which Hooke's law holds.

In order to maintain the good bonding characteristics of an inventive wire, it is generally preferred that a total amount of copper of the wire core is at least 97%. More preferred, the amount of copper is at least 98%.

In one preferred embodiment of the invention, the wire core consists of pure copper. Preferably, the purity is at least 3N-grade copper (>= 99.9 % Cu), most preferred 4N-grade copper (>= 99.99 % Cu). Pure copper wires generally show a good conductivity and good bonding properties.

In a preferred embodiment, a content of boron in the wire core is less than 100 ppm. As boron is known to influence the crystal structure of a copper based wire, keeping the boron amount below certain thresholds is advantageous. This is especially true for wire cores consisting of pure copper. In the case of another preferred embodiment, boron is provided in a controlled manner in an amount between 10 ppm and 100 ppm.

In yet another preferred embodiment, a content of phosphorus in the wire core is less than 200 ppm. It may be provided that phosphorus is avoided as far as possible (trace level), although in some embodiments, phosphorus can be provided in small amounts. In such cases, a preferred amount of phosphorus is between 10 ppm and 200 ppm.

In another preferred embodiment, the wire core contains palladium in an amount between 0,5 % and 3 %, more preferred between 1.0 % and 2.5 %. In even more preferred, optimized embodiments, the palladium content is between 1.2% and 2.5 %, and most preferred between 1.2% and 2.0 %. In a particularly preferred embodiment, the palladium share is between 1.2 % and 1.3 %. Experiments have shown that a small share of palladium does not reduce the beneficial effects of the present invention, while such palladium content generally helps a stability of the wire against corrosion and has further beneficial effects.

Further preferred, such Pd-containing wires of the invention show a microhardness of the wire core in a range of 85 to 95 HV (0.010 N / 5 s). In even more optimized embodiments,a ratio between the hardness and the palladium content of the wire core is in a range between 60 and 120 HV (0.01 N / 5 s) / wt.-%. It is understood that the hardness of the wire core can be adjusted independently from the chosen palladium content within certain ranges, for example by means of annealing procedures.

In a yet further preferred embodiment, the wire core contains silver in an amount between 45 ppm and 900 ppm. In a preferred embodiment, the silver content is between 100 ppm and 900 ppm, even more preferred between 100 ppm and 700 ppm. In a very preferred embodiment, the silver content is in the range of 100 ppm to 400 ppm, as significantly advantageous properties of the wire are obtained. In a yet further optimized embodiment, the silver content of the core is between 100 ppm and 300 ppm, most preferred between 200 ppm and 250 ppm. Generally, such embodiments with small shares silver in the wire core show a good FAB (Free Air Ball) forming and a large bonding window for ball-bonding.

Generally preferred for silver containing wires, a total amount of components of the wire core other than Cu and Ag is less than 1000 ppm, even more preferred less than 100 ppm. This provides for a good reproducibility of the wire properties.

In further preferred embodiments of an inventive wire, Au is provided as a share in an amount between 45 ppm and 900 ppm. More preferably, the amount of a Au is between 100 ppm and 700 ppm, most preferred between 100 ppm and 300 ppm.

It is noted that two or more of the above mentioned shares of Pd, Au, Ag, P and B can be provided simultaneously in an inventive wire. Most preferred, a share of Pd in one of the above mentioned amounts is combined with one share selected from the group of Au, Ag, P or B in amounts as mentioned above, respectively.

Generally preferred, beneficial upper thresholds for unwanted contamination levels of specific elements in the wire core of an inventive wire are as follows:

Ag:<35ppm;
Ni: <15 ppm;
Pd, Au, Pt, Cr, Ca, Ce, Mg, La, Al, B, Zr, Ti: <2 ppm in each case;
P: <6 ppm;
Fe: <10 ppm;
S, Mn: <15 ppm.

It is pointed out that the above general thresholds for the elements Pd, Ag, Au, B and P are only valid for embodiments of the invention in which these elements are not explicitly contained in other defined amounts.

Each of the above specific contaminant limits is meant to be a separate feature of the invention.

The present invention is particularly related to thin bonding wires. The observed effects are specifically beneficial to thin wires, in particular concerning control of the grain size. In the present case, the term 'thin wire" is defined as a wire having a diameter in the range of 8 $\mu$m to 80 $\mu$m. Particularly preferred, a thin wire according to the invention has a diameter in the range of 12 $\mu$m to 55 $\mu$m. In such thin wires, the inventive composition and annealing particularly helps to achieve beneficial properties.

In a preferred embodiment of an inventive wire, the wire core has been annealed at a temperature of at least 580 °C for a time of at least 0.1 s prior to a bonding step. This ensures a sufficient annealing and achievement of the demanded grain size, in particular in the case of thin wires. Even more preferred, the annealing time is at least 0.2 s and most preferred 0.25 s. The particularly high annealing temperature of an inventive wire generally allows for the adjustment of large average grain sizes. In a most preferred case the annealing temperature is chosen above 600 °C.

In particular, the annealing of the wire can be optimized under consideration of the wire diameter. In such optimized embodiments, the minimum annealing temperature is chosen as follows:

| Diameter [µm] | minimum annealing temperature [°C] |
|---|---|
| 15-28 | 600 |
| 28-38 | 610 |
| 38-50 | 625 |
| 50-80 | 635 |

In a generally preferred aspect of the invention, an elongation value of the wire after annealing is not more than 92% of a maximum elongation value. More preferred, the elongation value is not more than 85% and most preferred not more than 80% of the maximum elongation value. In a yet further preferred case, the wire is annealed at a temperature which is at least 10 °C higher than a temperature at which the maximum elongation value is achieved by annealing. More preferably, the temperature is at least 50 °C above the temperature of the maximum elongation and most preferred, the temperature is at least 80 °C above the temperature of the maximum elongation.

The maximum elongation value is defined as follows: In the general case of a copper based bonding wire, the elongation of the wire can be adjusted by a final annealing step. "Final" in this respect means that no production steps with major impact on the wire's morphology are established thereafter. When choosing the annealing parameters, usually a set of parameters is chosen. In a simple case of annealing the wire, a constant temperature is adjusted in an oven of a given length, wherein the wire is passing through the oven at a constant speed. This exposes every point of the wire to the temperature for a given time, this temperature and this annealing time being the two relevant parameters of the annealing procedure. In other cases, a specific temperature profile of the oven might be used, hence adding further parameters to the system.

In any case, one of the parameters can be chosen as a variable. Then the received elongation value of the wire dependent on this variable results in a graph which generally has a local maximum. This is defined as the maximum elongation value of the wire in the sense of the invention. In case the variable is the annealing temperature, such graph is usually referred to as the "annealing curve".

In prior art, it has been usual to anneal any wire to such maximum elongation value with respect to the variable parameter, as the presence of a local maximum provides for a particularly stable manufacturing condition.

With respect to the present invention, it surprisingly turned out that annealing to a different value below the maximum elongation value can result in beneficial wire properties as the wire morphology can be influenced in a positive way. If the annealing temperature is chosen as the variable parameter, and setting the annealing time as a constant value, it is particularly beneficial if the annealing temperature is chosen at a value which is higher than the annealing temperature of the maximum elongation. In particular, this manufacturing principle can be used to adjust the average grain size of the wire, e.g. to larger grain sizes. By this adjustment, other properties like e.g. wire softness, ball-bonding behavior etc. can be influenced in a positive manner.

In a possible further development of the invention, a coating layer is superimposed over the surface of the core. It is understood that such coating layer is a possible, but not necessary feature of an inventive wire. In order to minimize the influence of the material of such coating layer on the bonding process, a mass of the coating layer is preferably not more than 3 % of the mass of the wire core. Most preferably, the mass of the coating layer is not more than 1.0 % of the mass of the wire core. Advantageously, the coating layer comprises at least one of the group of Pd, Au, Pt and Ag as a main component.

The term "superimposed" in the context of this invention is used to describe the relative position of a first item, e.g. a copper core, with respect to a second item, e.g. a coating layer. Possibly, further items, such as an intermediate layer, might be arranged between the first and the second item. Preferably, the second item is at least partially superimposed over the first item, e.g. for at least 30 %, 50 %, 70 % or for at least 90 % with respect to the total surface of the first item. Most preferably, the second item is completely superimposed over the first item. The term "intermediate layer" in the context of this invention is a region of the wire between the copper core and the coating layer. In this region, material as in the core as well as material as in the coating layer is present in combination.

In case of a preferred embodiment of the invention, a hardness of the wire core prior to bonding is not greater than 95.00 HV (0.010N/5s). More preferred, the hardness is not more than 93 HV (0.010N/5s). Such softness of the wire core helps to prevent a sensitive substrate from damage in the course of bonding. Experiments have also shown that such soft wires according to the invention exhibit very good free air ball (FAB) properties. Such limitation of wire hardness is particularly helpful if mechanically sensitive structures are aligned below the bond pad. This is particularly true if the bond pad consists of a soft material like aluminium or gold. The sensitive structure can, for example, comprise one or several layers of porous silicon dioxide, in particular with a dielectric constant of less than 2.5. Such porous and hence weak material is becoming increasingly common as it can help to increase the device performance. Therefore, the mechanical properties of the inventive bonding wire are optimized to avoid cracking or other damaging of the weak layers.

Hardness was measured using Fischer scope H100C tester with Vickers indenter. If no differing values are given, a force of 10mN force (F) for 5s dwell time was applied, indented using a 135° square diamond indenter. The hardness test procedure was as per manufacturer's recommendation based on the basic well established procedure of Vickers indentation on a flat face of the cross-sectioned sample. The indentation diagonals (d) on the wire sectioned surface were measured using Scanning Electron Microscope (SEM) and calculated using the formula

$$HV = \frac{F}{A} = \frac{F}{d^2/2Sin(136°/2)},$$ where, F is in kgf and d is in mm.

A further aspect of the invention is a module, comprising a first bond pad, a second bond pad and a wire according to the invention, wherein the wire is connected to one of the bond pads by means of ball-bonding.

Such module can comprise any particular electronic device which is electrically connected by means of a bonding wire. In particular, the device can be an integrated circuit, a light emitting diode (LED), a display device or the like.

In a preferred embodiment of an inventive module, a process window area for the ball bonding has a value of at least 120 g*mA in the case of bonding a wire of 20 $\mu$m diameter to an aluminium bond pad. More preferred, the value is at least 130 g*mA, and most preferred the value is at least 140 g*mA.

These values of a ball-bonding window area are measured by standard procedure. The test wires have been bonded using a KNS-iConn bonder tool. The definition of a process window area for bonding wires is known in the art and is widely used to compare different wires. In principle, it is the product of an ultrasonic energy used in the bonding and a force used in the bonding, wherein the resulting bond has to meet certain pull test specifications, e.g. a pull force of 3 grams, no non-stick on pad etc.. The actual value of the process window area of a given wire further depends on the wire diameter as well as the bond pad material. In order to give a specific definition of the properties of an inventive wire, the claimed process window value is based on a wire diameter of 20 $\mu$m = 0.8 mil, wherein the bond pad consists of aluminium (Al, Al-0.5Cu, Al-1-Si-0.5Cu etc.). The scope an inventive system is not limited to wires of this diameter and bond pads made of aluminium, but names this data only for definition purpose.

A yet further aspect of the invention is a method for manufacturing a bonding wire according to the invention, comprising the steps of

    a. providing a copper core precursor with a demanded composition;
    b. drawing the precursor until a final diameter of the wire core is reached;
    c. annealing the drawn wire at a defined temperature for a minimum annealing time.

In a particularly preferred embodiment, the annealing is performed by strand annealing, allowing for a fast production of the wire with high reproducibility. Strand annealing means that the annealing is done dynamically while the wire is moved through an annealing oven and spooled onto a reel after having left the oven.

DESCRIPTION OF THE FIGURES

The subject matter of the invention is exemplified in the figures. The figures, however, are not intended to limit the scope of the invention or the claims in any way.

In Figure 1, a wire 1 is depicted.

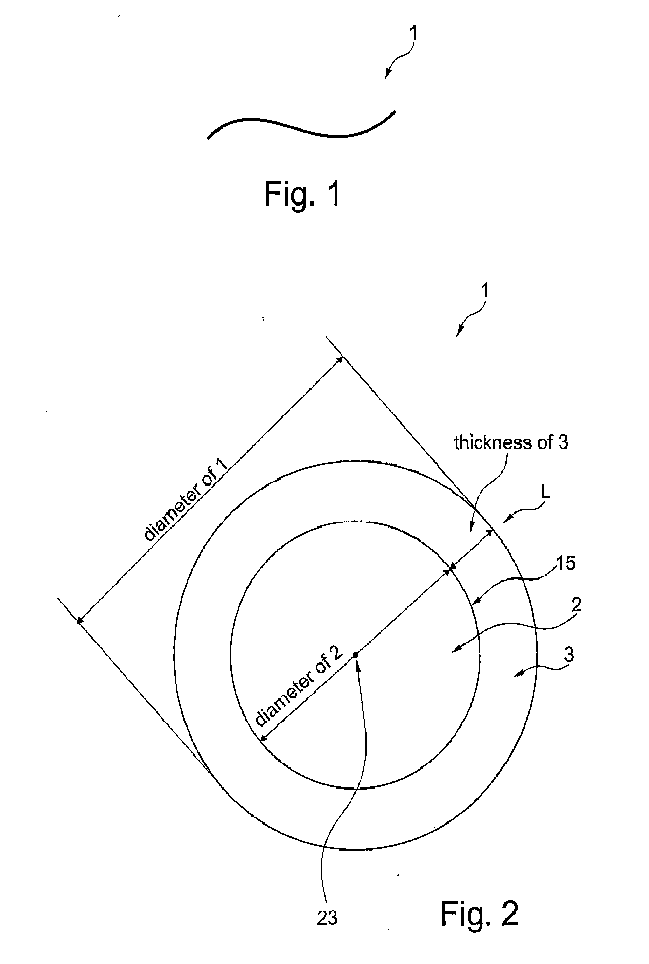

Figure 2 shows a cross sectional view of wire 1. In the cross sectional view, a copper core 2 is in the middle of the cross sectional view. The copper core 2 is encompassed by a coating layer 3. On the limit of copper wire 2, a surface 15 of the copper core is located. On a line L through the center 23 of wire 1 the diameter of copper core 2 is shown as the end to end distance between the intersections of line L with the surface 15. The diameter of wire 1 is the end-to-end distance between the intersections of line L through the center 23 and the outer limit of wire 1. Besides, the thickness of coating layer 3 is depicted. The thickness of a coating layer 3 is exaggerated in fig. 2. If a coating layer 3 is provided, its typical thickness is very small compared to the core diameter, e.g. less than 1% of the core diameter. It is understood that the coating layer 3 of the wire 1 is optional in case of the present invention. For a most preferred embodiment, no coating layer is provided on the wire core.

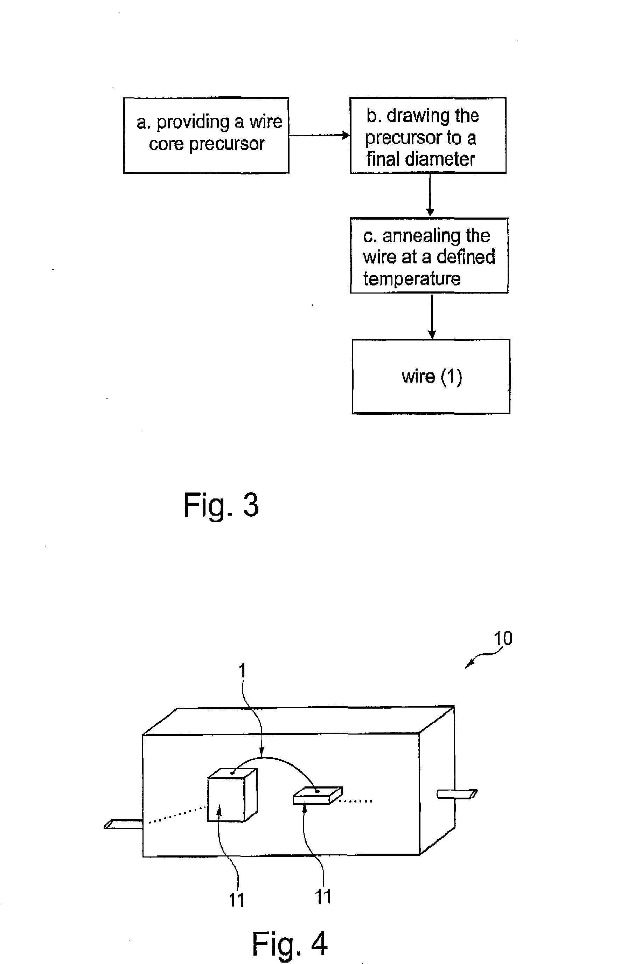

Figure 3 shows a process for manufacturing a wire according to the invention.

Figure 4 depicts a module in the form of an electric device 10, comprising two elements 11 and a wire 1. The wire 1 electrically connects the two elements 11. The dashed lines mean further connections or circuitry which connect the elements 11 with external wiring of a packaging device surrounding the elements 11. The elements 11 can comprise bond pads, lead fingers, integrated circuits, LEDs or the like.

Figure 5 shows a sketch of a wire pull test. To a substrate 20, a wire 1 is bonded in bonds 21 at an angle 19 of 45°. A pull hook 17 pulls wire 1. The angle 22, which is formed when the pull hook 17 pulls the wire 1, is 90°,

Fig. 6 shows a set of annealing curves for wires of different diameters of a first example of the invention. This example comprises wires consisting of a 4N-copper core without a coating.

Fig. 7 shows a diagram of a stitch pull measurement of a 25 $\mu$m wire of the first example in comparison with a conventional pure copper wire.

Fig. 8 shows a diagram of a hardness measurement of 20 $\mu$m and 25 $\mu$m wires of the first example in comparison with respective conventional pure copper wires.

Fig. 9 shows a comparison of a 2$^{nd}$ bond processing window of a wedge-bonding of a 25 $\mu$m wire of the first example compared to a bonding window of a conventional 25 $\mu$m pure copper wire.

Figure 10 shows an annealing curve of a 20 $\mu$m wire according to a second example of the invention. In this example, the copper of the wire core contains a small amount of silver.

Figure 11 shows a stitch pull comparison of a wire of the second example with a comparative wire.

Figure 12 shows a hardness comparison of a wire of the second example with a comparative wire.

Figure 13a shows a thermal aging behavior of a wire of the first example.

Figure 13b shows a thermal aging behavior of a wire of the second example.

Figure 14 shows a comparison of an average grain size for different 20 $\mu$m diameter wires of the first and second example of the invention.

Figure 15 shows a schematic diagram of a strand annealing device.

Figure 16 shows an annealing curve of a 20 $\mu$m wire according to a third example of the invention. In this third example, the copper of the wire core contains a small amount of palladium.

Fig. 17 shows a diagram displaying average grain sizes of a 20 $\mu$m wire of the third example. The data points on the left are measured on the wire and the data points on the right are measured on a free air ball of the wire.

Fig. 18 shows a diagram of a microhardness of the wire core, measured in different distances from a free air ball which is sited at 0 $\mu$m. A neck region between the free air ball and the unaffected wire region, as well as upto about 200 $\mu$m in the unaffected wire region. It is obvious that the wire has a microhardness within the range of 85 to 95 HV (0.010 N / 5 s).

Fig. 19 shows ball bond processing windows for 20 $\mu$m wires of the invention. One processing window relates to a wire of the first example of the invention (named "4N Soft Cu"), and the other processing window relates to a wire of the third example of the invention (named "Pd alloyed 1 N Cu").

Fig. 20 shows second bond ("stitch bond") processing windows for 20 $\mu$m wires of the invention. One processing window relates to a wire of the first example of the invention (named "4N Soft Cu"), and the other processing window relates to a wire of the third example of the invention (named "Pd alloyed 1 N Cu").

Figure 21 shows a thermal aging behavior of a 20 $\mu$m wire of the third example of the invention.

## TEST METHODS

All tests and measurements were conducted at T = 20 °C and a relative humidity of 50 %.

When measuring the average grain size of the crystal grains, the size of the grains is determined by using a standard metallographic technique. A sample of the wire core is cross-sectioned and then etched. In the present case, a solution of 2g $FeCl_3$ and 6 ml concentrated HCl in 200 ml DI-water was used for the etching. The grain sizes are measured and calculated by the line intercept principles. The grain size was measured along the longitudinal direction, which is the direction of the wire axis.

Measurement of ball-bonding process window area is done by standard procedure. The test wires have been bonded using a KNS-iConn bonder tool. The definition of a process window area for bonding wires is known in the art and is widely used to compare different wires. In principle, it is the product of an ultrasonic energy (USG) and a force used in the bonding, wherein the resulting bond has to meet certain pull test specifications, e.g. a pull force of 3 grams, no non-stick on pad etc.. The actual value of the process window area of a given wire further depends on the wire diameter as well as the bond pad material. In order to give a specific definition of the properties of an inventive wire, the process window value are presently based on a wire diameter of 20 $\mu$m = 0.8 mil, wherein the bond pad consists of aluminium (Al, Al-0.5Cu, Al-1 Si-0.5Cu, etc.). The four corners of the process window are derived by overcoming the two main failure modes:

(1) supply of too low force and USG lead to non-stick on bond pad (NSOP) of the FAB, and
(2) supply of too high force and USG lead to bond pad crater.

## EXAMPLES

The invention is further exemplified by examples. These examples serve for exemplary elucidation of the invention and are not intended to limit the scope of the invention or the claims in any way.

## Example 1

A quantity of copper material of at least 99.99 % purity ("4N-copper") is molten in a crucible. No further substances are added to the melt. Then a wire core precursor is cast from the melt.

The chemical composition of the Cu wire was controlled using an Inductively Coupled Plasma (ICP) instrument (Perkin Elmer ICP-OES 7100DV). The Cu wires were dissolved in concentrated nitric acid and the solution was used for ICP analysis. The methodology to test highly pure Cu wire was established with the equipment manufacturer as per the well-known technique adopted for bulk Cu.

The wire core precursor is then drawn in several drawing steps to form the wire core 2 with a specified diameter. In order to confirm the beneficial effects of the invention for different diameters, a selection of wires with different diameters have been manufactured. Table 1 below shows a list of the different wire diameters:

(Table 1: Ranges of elongation and average grain sizes for different wire diameters)

| Diameter, $\mu$m | Elongation (EL), % | Wire Grain size, $\mu$m | FAB Grain size, $\mu$m | Ratio = EL / Wire grain size | Ratios EEL / FAB grain size |
|---|---|---|---|---|---|
| 15.0 | 7.0-15.0 | 3.0-6.0 | 8.0-16.0 | 1.2-5.0 | 0.4-1.8 |
| 18.0 | 7.0-15.0 | 3.0-6.0 | 8.0-16.0 | 1.2-5.0 | 0.4-1.8 |
| 20.0 | 7.0-15.0 | 3.0-6.0 | 8.0-16.0 | 1.2-5.0 | 0.4-1.8 |
| 23.0 | 8.0-16.0 | 3.0-6.0 | 8.0-16.0 | 1.3-5.5 | 0.5-2.0 |
| 25.0 | 8.0-16.0 | 3.0-6.0 | 8.0-16.0 | 1.3-5.5 | 0.5-2.0 |
| 28.0 | 8.0-16.0 | 3.0-6.0 | 8.0-16.0 | 1.3-5.5 | 0.5-2.0 |
| 30.0 | 8.0-16.0 | 4.0-8.0 | 10.0-18-0 | 1.0-4.0 | 0.4-1.6 |
| 33.0 | 8.0-16.0 | 4.0-8.0 | 10.0-18.0 | 1.0-4.0 | 0-4-1.6 |
| 38.0 | 10.0-20.0 | 10.0-20.0 | 20.0-30.0 | 0.5-2.0 | 0.3-1.0 |
| 45.0 | 10.0-20.0 | 10.0-25.0 | 23.0-35.0 | 0.4-2.0 | 0.3-0.8 |

(continued)

| Diameter, μm | Elongation (EL), % | Wire Grain size, μm | FAB Grain size, μm | Ratio = EL / Wire grain size | Ratios EEL / FAB grain size |
|---|---|---|---|---|---|
| 50.0 | 10.0-20.0 | 10.0-30.0 | 25.0-40.0 | 0.3-2.0 | 0.2-0.8 |
| 63.0 | 10.0-25.0 | 10-0-30.0 | 25.0-45.0 | 0.3-2.5 | 0.2-1.0 |
| 75.0 | 10.0-25.0 | 10.0-30.0 | 25.0-45.0 | 0.3-2.5 | 0.2-1.0 |

Table 1 further shows ranges of elongation values and average grain sizes of the wire core. These ranges are preferred for a wire of the respective diameter, wherein an adjustment of these values according to the invention is described further below. Further, in the last two columns to the right, calculated values for a ratio between the elongation and the average grain size of the wire core have been added, as well as calculated values for a ratio between the elongation and an average grain size of a free air ball (FAB) as produced under standard conditions.

The cross section of the wire core 2 is of essentially circular shape. The wire diameter is not considered a highly exact value due to fluctuations in the shape of the cross section or the like. In the present sense, if a wire is defined to have a diameter of e.g. $20 \mu$ m, the diameter is understood to be in the range of 19.5 to 20.5 $\mu$m.

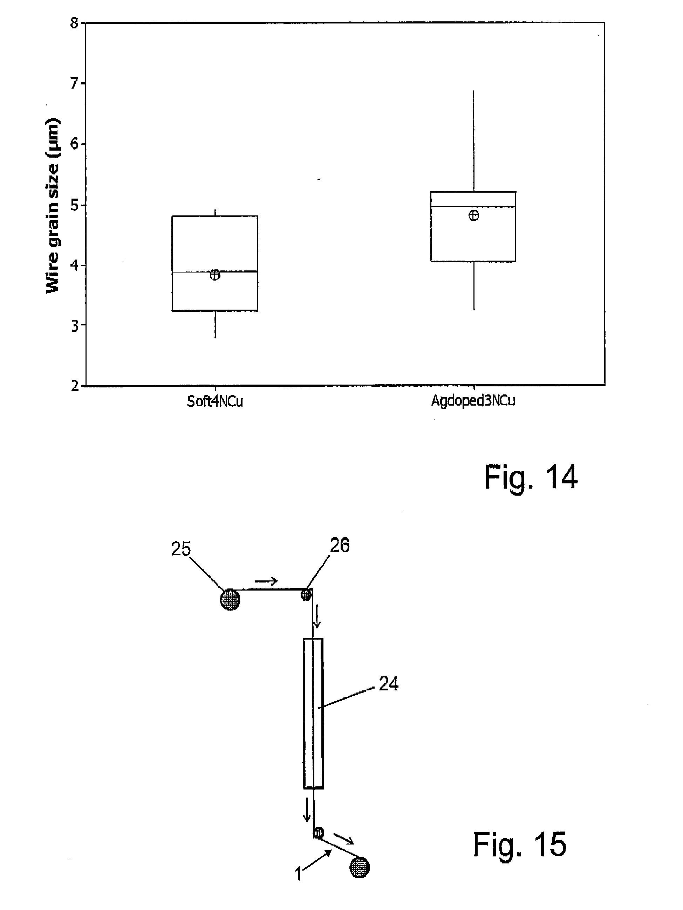

The wires are then annealed in a final annealing step in order to further adjust parameters like elongation, hardness, crystal structures and the like. The annealing is performed dynamically as strand annealing, by running the wire 1 through an annealing oven 24 of a defined length and temperature with a defined speed (see fig. 15). The wire is unspooled from a first reel 25 and guided by pulleys 26. After leaving the oven 24, the wire is spooled on a second reel for packaging.

In the present examples, the annealing time, which is the exposure time a given piece of the moving wire remains within in the heated oven 24, is about 0.3 s for all wire diameters. The annealing temperature in the case of the 20 $\mu$m diameter wires is selected at 600 °C. Within the oven zone, a constant temperature is adjusted.

In principle, the annealing time can vary according to the annealing temperature and/or the wire diameter. Anyway, if strand annealing is chosen as an annealing method, a certain minimum speed of the wire is demanded for in order to obtain a reasonable throughput. Therefore, the annealing time is preferably chosen in a region between 0.1 second and 1 second, which allows for easy provision of an oven of sufficient length. This, on the other hand, demands for sufficiently high annealing temperatures. Table 2 below shows preferred minimum annealing temperatures for different ranges of wire diameters:

(Table 2: Recommended minimum annealing temperatures)

| Diameter of wire [$\mu$m] | Range of average wire grain size [$\mu$m] | Preferred minimum annealing temp [°C] |
|---|---|---|
| 15-28 | 2.5-6.0 | 600 |
| 28-38 | 3.0-10.0 | 610 |
| 38-50 | 7.0-15.0 | 625 |
| 50-80 | 10.0-30.0 | 635 |

The average grain sizes of selected wire samples have been measured. The results are shown in table 3 below:

(Table 3: Average grain sizes for wires examples)

| Diameter of wire [$\mu$m] | Measured average wire grain size [$\mu$m] | Annealing temp [°C] |
|---|---|---|
| 20 | 5.0 | 600 |
| 33 | 6.5 | 615 |
| 50 | 11.0 | 630 |
| 80 | 20 (estimated) | 635 (estimated) |

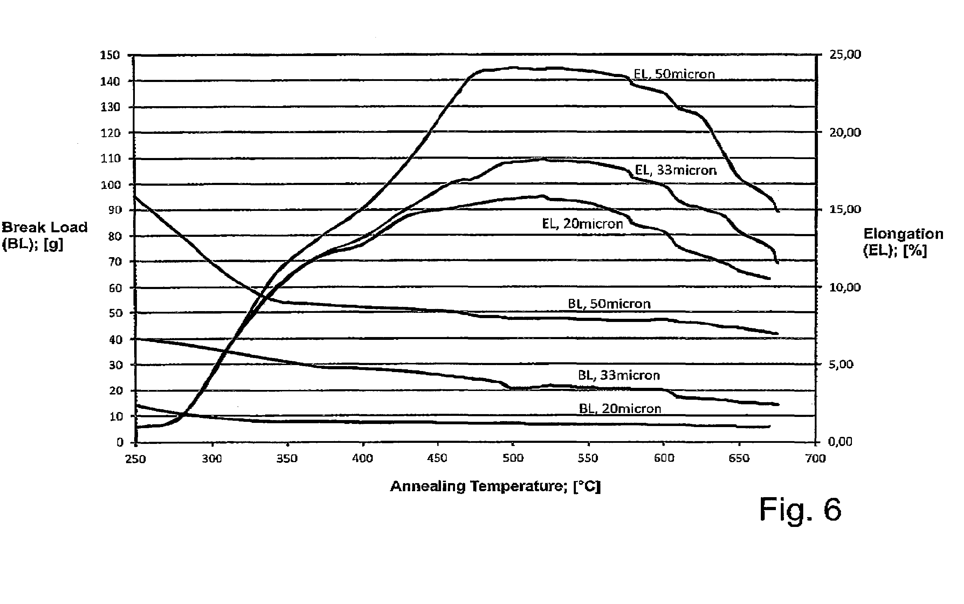

Figure 6 shows several exemplary annealing curves of 4N-copper wires according to inventive example 1. The wires differ only by their diameter, wherein wires of 20 $\mu$m, 33 $\mu$m and 50 $\mu$m diameter are shown. The annealing time is chosen to a constant value by adjusting the speed of the moving wire. The annealing temperature is the variable parameter of the x-axis. The graphs show the measured values for the break load (BL) and the elongation (EL) of the wire as a function of the temperature. The elongation exhibits typical local maxima in each case.

For the three exemplary wire diameters, a maximum value of the elongation can be estimated from the annealing curve as follows:

(Table 4: Values at maximum elongation for different wire diameters)

| Wire diameter | Annealing temp. of max. elongation [°C] | Max. elongation [%] | Break load [g] at max. elongation |
|---|---|---|---|
| 20 $\mu$m | 520 | 15.8 | 6.7 |
| 33 $\mu$m | 520 | 18.0 | 21.2 |
| 50 $\mu$m | 525 | 24.1 | 47,4 |

The wires according to the invention are not annealed at the respective temperatures of maximum elongation, but at higher temperatures:

For the 20 $\mu$m wire, the chosen annealing temperature is 600 °C, which is 80 °C above the temperature of the maximum elongation according to table 4. This results in an elongation value of about 11.8 % (see below table 5), which is 25 % below the maximum elongation value of 15.8 %.

For the 33 $\mu$m wire, the chosen annealing temperature is 615°C, which is 95 °C above the temperature of the maximum elongation according to table 3. This results in an elongation value of about 13.3 %, which is 26 % below the maximum elongation value of 18.0 %.

For the 50 $\mu$m wire, the chosen annealing temperature is 630 °C, which is 105 °C above the temperature of the maximum elongation according to table 3. This results in an elongation value of about 18.5 %, which is 23 % below the maximum elongation value of 24.1 %.

Such annealing at a high temperature side of a maximum of the annealing curve means to be working in a rather sensitive range of the material in terms of process parameters. In order to have a good reproducibility of the results, the entire set of parameters has to be monitored carefully.

Table 5 below shows measured results of further mechanical and electrical properties of the inventive wires from table 3:

(Table 5: mechanical and electrical properties)

| Diameter, $\mu$m | Vickers Hardness, HV(10mN/5s), | | Tensile Properties | | | | Resistivity, $\mu\Omega$.cm |
|---|---|---|---|---|---|---|---|
| | Wire | FAB | Elongation, % | Yield strength, MPa | Tensile strength, MPa | Young's Modulus, GPa | |
| 20 | 90 | 85 | 11.8 | 74 | 220 | 90 | 1.69 |
| 33 | 93 | 88 | 13.3 | 72 | 225 | 92 | 1.69 |
| 50 | 91 | 89 | 18.5 | 75 | 224 | 92 | 1.69 |

The results from table 5 show that the inventive wires have as low values for electrical resistivity as typically known from 4N-copper-wires.

The yield strength, as expected, is not related to the wire diameter. The values of the inventive wires are well below 120 MPa in each case, and even well below 80 MPa. Typical prior art 4N-copper-wires, which have been annealed around the maximum of the elongation value, have a yield strength of more than 160 MPa.

The Young's modulus is also independent from the wire diameter and has values well below 100 GPa. Typical prior art 4N-copper-wires have a Young's modulus of about 125 GPa.

The tensile strength, which is also independent from the wire diameter as expected, is around 225 MPa. It is noted that typical prior art 4N-copper-wires have been measured with a tensile strength of around 245 MPa. The tensile strength of wires according to the invention is typically a few percent below the values of standard wires. This would be expected due to the softness of the inventive wires. Anyway, such small decrease in tensile strength would not result in negative effects on standard bonding procedures and/or use with standard bonding equipment.

The Tensile properties of the wires were tested using an Instron-5300 instrument. The wires were tested at 1 (one) inch/min speed, for 10inch gauge length. The break load and elongation were acquired as per ASTM standard F219-96. The Young's modulus and yield load (yield strength) of the fine wires were obtained by the method established by the manufacturer: Draw a tangential line along the elastic region of the tensile plot. Measure the slope of the line, which represents Young's modulus of the wire. The load measured at the start of the plastic region defines the yield strength. "Bluehill software" developed by the manufacturer was capable to attain the yield load and Young's modulus directly from the tensile plot. The yield strength (Engineering strength) was calculated using the formula Yield strength = Yield load / area of wire cross section. The diameter was measured by a weighing method as per ASTM standard F205.

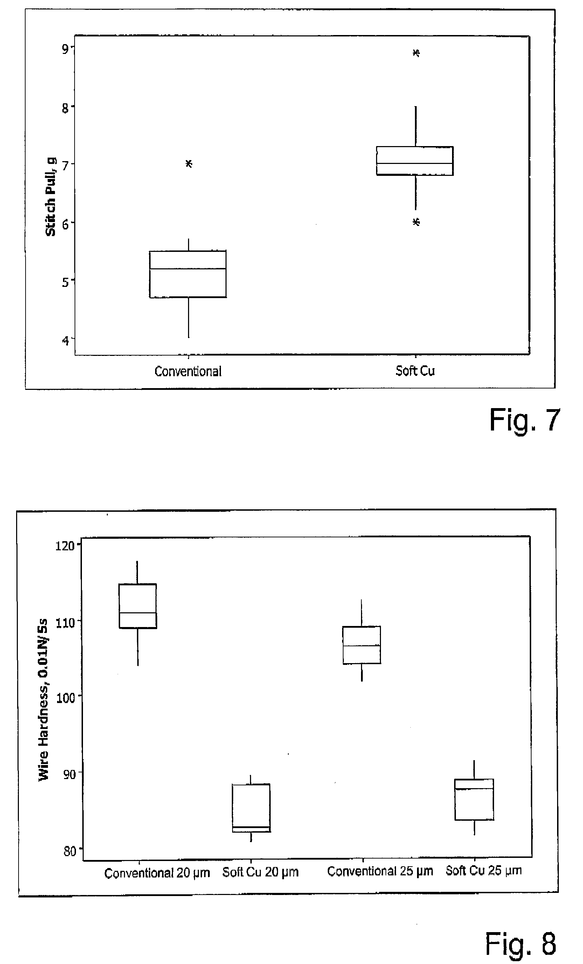

Further results and comparisons of wires of the first example are shown in figures 7, 8 and 9.

In fig. 7, a stitch pull comparison of 25 $\mu$m wires show that wires according to the invention have even greater stich-pull-values when compared to prior art wires. The results of the inventive wire according to example 1 are shown on the right and tagged "Soft Cu".

In fig. 8, a hardness comparison of 20 $\mu$m wires and 25 $\mu$m wires is shown. In each case, the measured Vickers hardness 10mN/5s of a prior art wire ("conventional") and an inventive wire of example 1 ("Soft Cu") is displayed. It is obvious that the inventive wires have a significantly lower Vickers Hardness which is in a range below 90 HV 10mN/5s for these diameters.

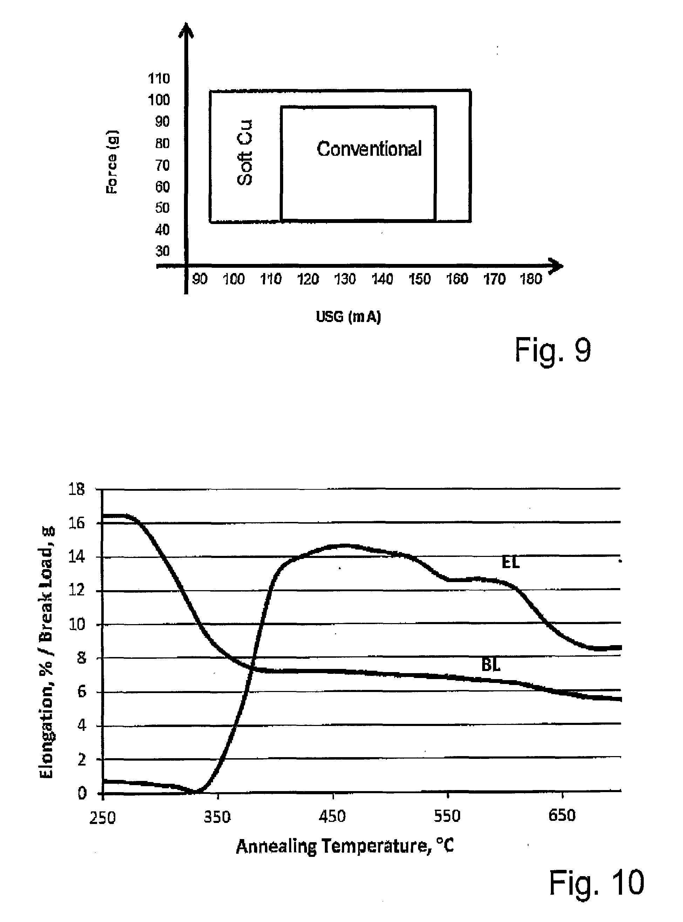

In fig. 9, bonding process windows of a ball bonding are displayed for a prior art wire ("Conventional") and an inventive wire ("Soft Cu") according to example 1. The wire diameters have been chosen to 20 $\mu$m, and the test bonding was performed on an aluminium bond pad. It is obvious that the process window for the inventive wire is significantly larger than the window of the conventional wire.

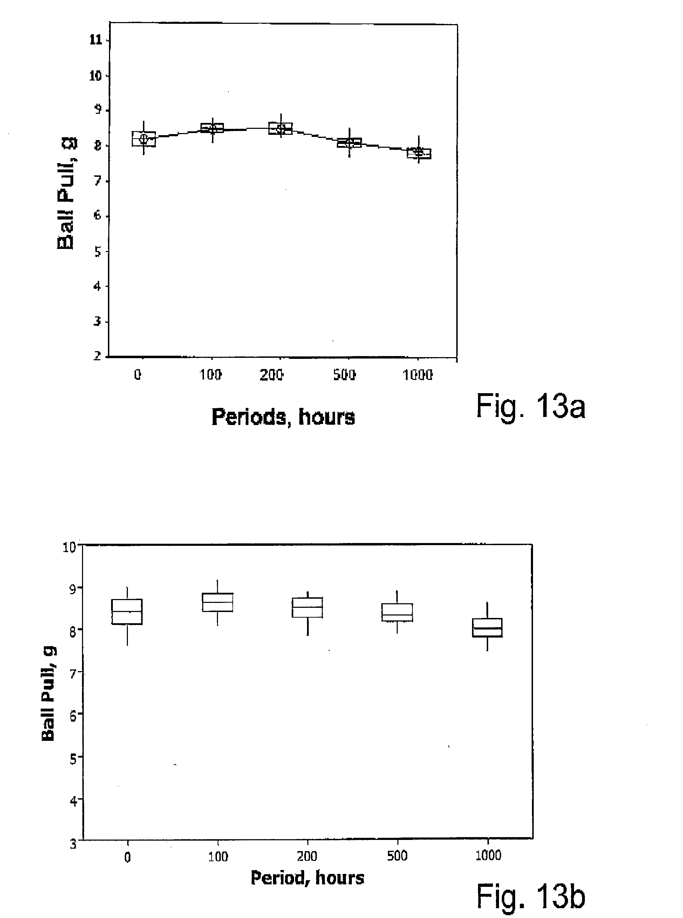

Figure 13a shows of a thermal aging experiment of the 25 $\mu$m 4N Cu wire sample. A ball pull value of the ball-bonded sample has been measured, wherein the samples have been aged under thermal exposition at 175 °C for up to 1000 hours. The results show a very good aging behavior of the wire. The results also prove that wires according to the invention are suitable for high temperature and/or high energy applications.

Although the above examples concern wires made from pure copper (4N-purity), the invention is not limited to wires of such purity. The basic inventive concept of high temperature annealing with controlled growth of larger grains and adjustment to lower elongation values can be transferred to any suitable wire system based on copper. Particular preferred, but not limiting the scope of the invention, are the systems of table 6 below:

(Table 6: Preferred systems for copper wires according to the invention)

| System No | Pd (wt%) | Au (ppm) | Ag (ppm) | P (ppm) | B (ppm) | Cu |
|---|---|---|---|---|---|---|
| 1 | 1-3 | - | - | - | - | balance |
| 2 | - | 45-900 | - | - | - | balance |
| 3 | - | - | 45-900 | - | - | balance |
| 4 | - | | - | 10-200 | - | balance |
| 5 | - | - | - | - | 10-100 | balance |
| 6 | 1-3 | 45-900 | - | - | - | balance |
| 7 | 1-3 | - | 45-900 | - | - | balance |
| 8 | 1-3 | - | - | 10-200 | - | balance |
| 9 | 1-3 | - | - | - | 10-100 | balance |

All shares of the listed elements are understood as being present in the wire core. The systems of table 6 are not related to an optional coating of the wire core, which may be additionally provided in each case.

If no share of an element is given ("-"), the element should not be present above a tolerable trace level. It is understood that further combinations of elements than those given in table 6 are possible. In particular, further combinations of the elemental shares of table 6 can be thought of, for example a share of silver combined with a share of gold etc.. Also, adding further elements than those named in table 6 can be advantageous.

Generally preferred, a total amount of copper in the wire core is not much lower than 97%, which provides for a good applicability of the invention.

in the following, further examples of inventive wires are described in detail. These examples comprises a small amount of silver in the core and hence correlate to the suggested system No 3 in table 6, although not being limited to the specific set of elemental shares given for this system in table 6.

Example 2

A quantity of copper material of at least 99.99 % purity ("4N-copper") is molten in a crucible. Small amounts of silver (Ag) are added to the melt and an even distribution of the added components in the copper melt is provided. Then a wire core precursor is cast from the melt.

The wire core precursor is then drawn in several drawing steps to form the wire core 2 with a specified diameter of presently 20 μm. The cross section of the wire core 2 is of essentially circular shape. It is to be understood that the wire diameter is not considered a highly exact value due to fluctuations in the shape of the cross section or the like. In the present sense, if a wire is defined to have a diameter of e.g. 20 μm, the diameter is understood to be in the range of 19.5 to 20.5 μm.

By means of this procedure, several different samples of an inventive wire and a comparative wire have been manufactured.

(Table 7: Wire diameter 20 μm, values in ppm)

| Sample | Ag | Ni | Pd, Au, Pt, Cr, Al, B, Zr, Ti | Ca, Ce | Mg, La | P | S | Fe | Mn |
|--------|-----|------|-------------------------------|--------|--------|-----|------|------|------|
| 4N Cu | <25 | <15 | <2 | <2 | <2 | 6 | <10 | <10 | <15 |
| 1 | 45 | <15 | <2 | <2 | <2 | <6 | <10 | <10 | <15 |
| 2 | 110 | <15 | <2 | <2 | <2 | <6 | <10 | <10 | <15 |
| 3 | 225 | <15 | <2 | <2 | <2 | <6 | <10 | <10 | <15 |
| 4 | 350 | <15 | <2 | <2 | <2 | <6 | <10 | <10 | <15 |
| 5 | 900 | <15 | <2 | <2 | <2 | <6 | <10 | <10 | <15 |

Table 7 above shows the composition of different samples numbered 1..5 of an inventive wire of 20 μm diameter. The silver content of the wires is 45 ppm, 110 ppm, 225 ppm, 350 ppm and 900 ppm, respectively. A comparative wire consisting of copper of 4N purity has been added.

The wires are then annealed in a final annealing step in order to further adjust parameters like elongation, hardness, crystal structures and the like. The annealing is performed dynamically as strand annealing, by running the wire 1 through an annealing oven 24 of a defined length and temperature with a defined speed (see fig. 15). The wire is unspooled from a first reel 25 and guided by pulleys 26. After leaving the oven 24, the wire is spooled on a second reel for packaging.

In the present examples the annealing time, which is the exposure time a given piece of the moving wire is remaining within the heated oven 24, is about 0.3 s. The annealing temperature in the case of the 20 μm diameter wires is selected at 640 °C. Within the oven zone, a constant temperature is adjusted.

Figure 10 shows an exemplary annealing curve of a silver-doped 20 μm copper wire. The annealing time is chosen to a constant value by adjusting the speed of the moving wire. The annealing temperature is the variable parameter of the x-axis. The graphs show the measured values for the break load (BL) and the elongation (EL) of the wire.

The elongation exhibits a typical local maximum value of about 14.5 % in the displayed example, which is achieved at an annealing temperature of around 460 °C.

Now the inventive wires according to samples 1..5 are not annealed at this temperature of maximum elongation, but at 640 °C, which is 180 °C above the temperature of the maximum elongation according to figure 10. This results in an elongation value of about 10%, which is more than 30% below the maximum elongation value.

As in example 1, such annealing at a high temperature side of the annealing curve means to work in a rather sensitive range of the material in terms of process parameters. In order to have a good reproducibility of the results, the entire set of parameters has to be monitored carefully.

The average grain sizes of wire samples No 1-5 have been measured. The result is in the range of 3 μm to 6 μm in each case. For sample No. 3, the average grain size is 5 μm.

The average grain size of the wire core is largely affected by the annealing step, and there is further influence by the silver content.

Further experiments have shown that for wires with diameters in the range of 15..28 μm, an average grain size in the range of 3..6 μm can be achieved and is preferred for the entire range of silver content, i.e. from 45 ppm to 900 ppm.

Table 8 below shows results of an evaluation on ball bonding performance. The above defined inventive wire samples 1..5 as well as the comparative example of a pure copper wire have been tested for ball bonding as described above under "test methods"

(Table 8: Process windows for ball bonding)

| 1st Bond Process Window | | | |
|-------------------------|---------|---------|--------|
| Wire sample | 4 N C u | 1 | 2 |
| USG (mA) | 80 ~ 94 | 80 ~ 94 | 76 ~ 9! |

(continued)

| 1st Bond Process Window | | | |
|---|---|---|---|
| Force (g) | 20 ~ 28 | 20 ~ 26 | 20 ~ 28 |
| Window Area (g*mA) | 11 2 | 84 | 15 2 |

The process window areas are defined as the product of the respective differences between upper and lower borders of the ultrasonic energy and the applied force.

All of the inventive wires result in process windows which are well suited for industrial application. In particular, inventive wires samples 2, 3 and 4 show values of more than 120 mA*g and above, which is a particular improvement compared to the 4N Cu wire. Hence an improvement of the ball bonding process window is present at least in a range of 100..350 ppm of Ag content.

It is understood that the beneficial properties of the wires according to the invention are not limited to a singular parameter like a ball-bonding process window. Other properties are, for example, the FAB shape and reproducibility, FAB hardness, the softness of the wire before bonding, the softness of the wire in the bonding area (ball and neck) after bonding, the electrical conductivity of the wire, the stitch pull strength, the aging behavior, and more.

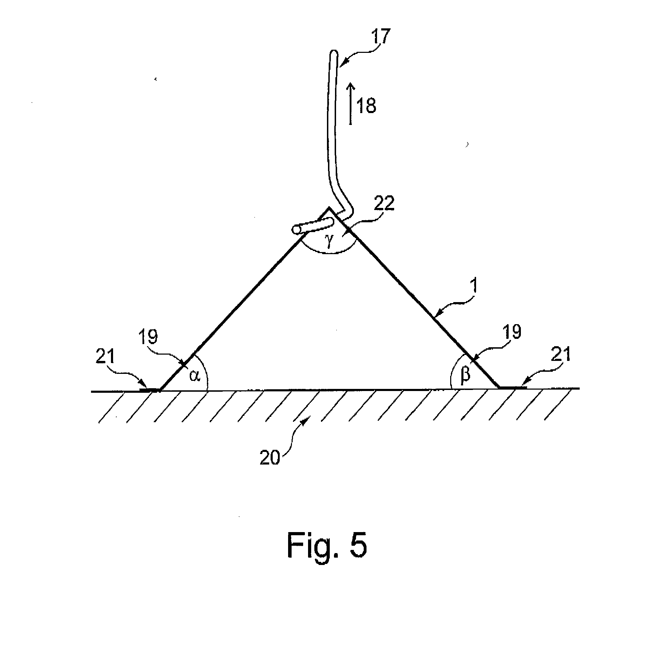

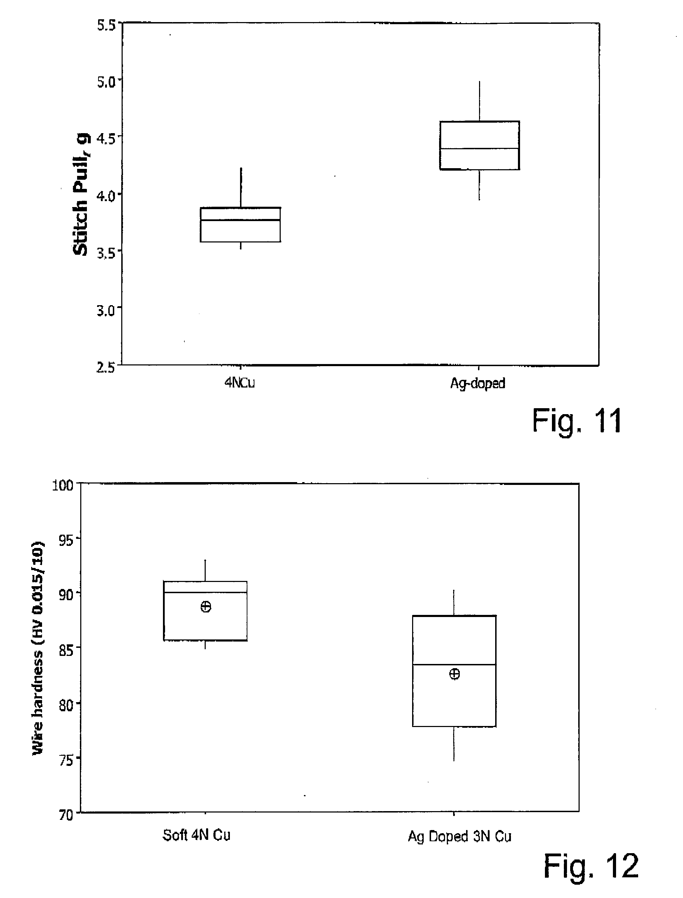

Figure 11 shows a comparison of a stitch pull value of the wire sample No. 3 (225 ppm silver content) with the comparative 4N copper sample. The inventive wire shows an improved stitch pull value. The measurements have been made according to figure 5.

Figure 12 shows a comparison of a hardness value (HV 15mN/10s) of the wire sample No. 3 with a 4N copper sample of inventive example 1 (tagged "Soft 4N Cu"). The inventive wire of the second example has an even lower hardness than the wire from the first example, although there is some overlap of the error bars of the measurement.

Figure 13b shows of a thermal aging experiment of the wire sample No. 3. A ball pull value of the ball-bonded sample has been measured, wherein the samples have been aged under thermal exposition for up to 1000 hours. The results show a very good aging behavior of the wire.

Figure 14 shows a comparison of measured average grain sizes of the sample No 3 Ag-doped wire of example 2 of the invention and a 20 $\mu$m 4N-Cu-wire. The 4N-Cu-wire has been annealed according to the invention as described above under "example 1". The 4N-Cu-wire is tagged "Soft4NCu". There is a strong overlap of the error bars of the measurement, but a tendency to larger grain sizes in case of the Ag-doped wire can be estimated.

With reference to the results of example 2 described above for a 20 $\mu$m diameter wire, a preferred and optimized version of an inventive wire has a silver content in the range of 45..900 ppm. This also appears true for all further examined diameter ranges of bonding wires.

Based on this range of silver content, wires with other diameters have been optimized with respect to the average grain size, softness of the wire core and ball-bonding behavior.

For a wire of 33 $\mu$m diameter, an optimized annealing temperature of 650 °C has been found. Other parameters and the method of manufacturing the wire have remained unchanged compared to the wire of example 1.

Further experiments have shown that for wires with diameters in the range of 28..38 $\mu$m, an average grain size in the range of 4..10 $\mu$m can be achieved and is preferred for the entire variation range of silver content, i.e. from 45 ppm to 900 ppm.

For a wire with 33 $\mu$m diameter and 226 ppm silver content, an average grain size of 6 $\mu$m has been achieved by annealing at 650 °C.

For a wire of 50 $\mu$m diameter, an optimized annealing temperature of 670 °C has been found. Other parameters and the method of manufacturing the wire have remained unchanged compared to the wire of example 1.

Further experiments have shown that for wires with diameters in the range of 38..50 $\mu$m, an average grain size in the range of 8..15 $\mu$m can be achieved and is preferred for the entire variation range of silver content, i.e. from 45 ppm to 900 ppm.

For a wire of 50 $\mu$m diameter and 225 ppm silver content, an average grain size of 15 $\mu$m has been achieved by annealing at 670 °C.

Example 3

A quantity of copper material of at least 99.99 % purity ("4N-copper") is melted in a crucible. Small amounts of palladium (Pd) are added to the melt and an even distribution of the added component in the copper melt is provided. Then a wire core precursor is produced by continuously and slowly casting the melt into rods of between 2 mm and 25 mm diameter.

The wire core precursor is then drawn in several drawing steps to form the wire core 2 with a specified diameter

of presently 20 μm. The drawing is conducted as cold drawing at room temperature.

Concerning the cross section shape of the wire core 2, reference is made to the remarks for the above examples.

By means of this procedure, several different samples of an inventive wire have been manufactured. In a first variant, the amount of palladium in the copper has been adjusted to 0.89 %. In a second, most preferred variant, the amount of palladium has been adjusted to 1.25 %.

Concerning thresholds of impurities of further elements, reference is made to the above second example of the invention, see table 7. It is noted that a silver content in case of the third example is preferably below 25 ppm. Anyway, it turned out that in case of a palladium containing copper wire according to the invention, even higher amounts of silver are tolerable or can even have beneficial effects. In particular, reference is made to above table 6 of the first example, wherein several examples of Pd-containing wires are mentioned. Such combinations are understood as preferred further variants of wires according to the third example of the invention.

The wires are then annealed in a final annealing step in order to further adjust parameters like elongation, hardness, crystal structures and the like. The annealing is performed dynamically as strand annealing, by running the wire 1 through an annealing oven 24 of a defined length and temperature with a defined speed (see fig. 15). The wire is unspooled from a first reel 25 and guided by pulleys 26. After leaving the oven 24, the wire is spooled on a second reel for packaging.

In the present examples the annealing time, which is the exposure time a given piece of the moving wire is remaining within in the heated oven 24, is about 0.3 s. The annealing temperature in the case of the 20 μm diameter, Pd-containing wires is selected at 800 °C. Within the oven zone, a constant temperature is adjusted.

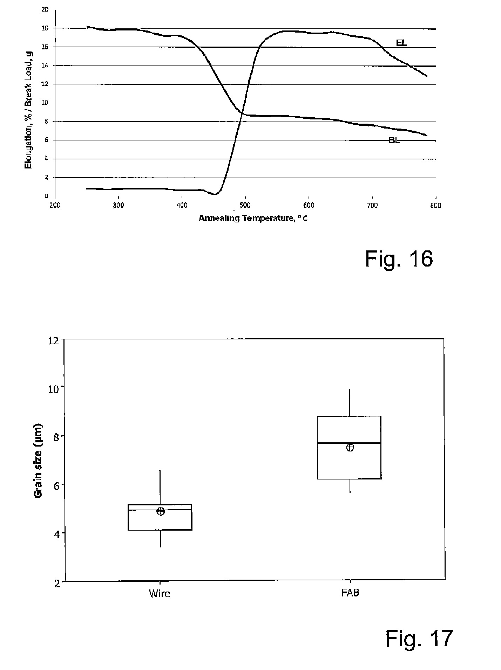

Figure 16 shows an exemplary annealing curve of a 20 μm copper wire of the first variant (1.25% palladium-alloyed). The annealing time is chosen to a constant value by adjusting the speed of the moving wire. The annealing temperature is the variable parameter of the x-axis. The graphs show the measured values for the break load (BL) and the elongation (EL) of the wire. The elongation exhibits a typical local maximum value of about 17.9 % in the displayed example of fig. 10, which is achieved at an annealing temperature of about 570 °C.

Now the inventive wires of the third example are not annealed at this temperature of maximum elongation, but at about 750°C, which is 180 °C above the temperature of the maximum elongation according to figure 16. This results in an elongation value of about 14%, which is more than 22% below the maximum elongation value of 17.9 %.

Table 9 below shows some measured values on the 20 μm wires of the third example of the invention:

(Table 9: Wire diameter 20 μm)

| Alloy/ Element | Hardness HV (10mN/5s) | | Tensile properties | | | | Resistivity, μΩ.cm |
|---|---|---|---|---|---|---|---|
| | Wire | FAB | Elongation, % | Tensile strength, MPa | Yield strength, MPa | Young's Modulus, GPa | |
| 4NCu | 90 | 85 | 11.8 | 220 | 78 | 90 | 1.69 |
| 0.89% Pd | 93 | 90 | 12.1 | 212 | 81 | 95 | 2.35 |
| 1.25% Pd | 94 | 91 | 14.0 | 214 | 82 | 97 | 2.35 |

It is noted that a comparative wire of the first example of the invention ("4NCu") is added, which is already listed in table 5 above.

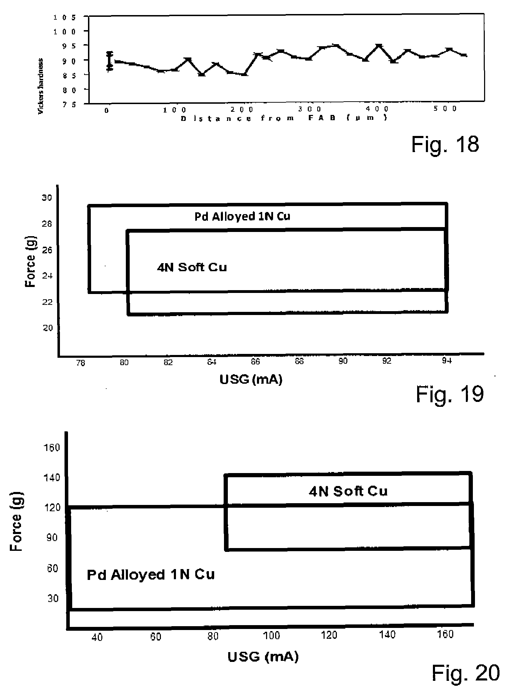

The values from table 9 show that Pd-alloyed wires have a slightly higher resistivity compared to pure copper wires, as expected. On the other hand, beneficial effects like improved corrosion resistance result from the Pd-alloying. The table further shows that Pd-containing wires can achieve very similar mechanical properties as pure copper wires (4NCu) if the annealing procedure according to the invention is conducted. In table 9, the hardness measurement has been conducted and averaged on the wire core (left value) and on the free air ball (FAB) after a standard ball formation procedure. Further detail hardness measurements of the 1.25 % Pd-alloyed 20 μm wire can be seen in the diagram of fig. 18. This diagram shows a multitude of measurements on the wire surface with increasing distance from a free air ball. A small decrease of the hardness is seen in the proximity of the FAB region.

Further variants of wires of the third example are listed in table 10 below:

(Table 10: Different wire diameters, Pd-content 1.25 %)

| Wire dia., μm | 1.25% Pd alloyed Cu | | | | | |
|---|---|---|---|---|---|---|
| | Wire | | | | | FAB |
| | wire hardness, HV | Tensile strength, MPa | Yield strength, MPa | Young's modulus, GPa | Elongation, % | hardness, HV |
| 12.5 | 95 | 204 | 78 | 92 | 11.7 | 89 |
| 15 | 91 | 209 | 80 | 93 | 12.0 | 88 |
| 18 | 93 | 206 | 79 | 92 | 12.2 | 91 |
| 20 | 95 | 207 | 81 | 95 | 12.1 | 90 |
| 23 | 94 | 204 | 77 | 94 | 11.9 | 89 |
| 25 | 92 | 210 | 76 | 94 | 12.0 | 85 |
| 28 | 92 | 205 | 77 | 89 | 15.0 | 90 |
| 30 | 90 | 206 | 78 | 92 | 15.5 | 86 |
| 33 | 91 | 210 | 77 | 92 | 14.9 | 87 |
| 38 | 89 | 204 | 78 | 93 | 16.0 | 88 |
| 45 | 91 | 208 | 77 | 93 | 16.2 | 89 |
| 50 | 92 | 204 | 80 | 94 | 21.0 | 90 |
| 63 | 95 | 205 | 78 | 92 | 22.0 | 87 |
| 75 | 93 | 209 | 79 | 92 | 22.5 | 89 |

It is apparent that the elongation values of the wires increase with the wire diameter. Nevertheless, the inventive principle of annealing to an elongation value below the respective maximum value is kept throughout all the different examples and wire diameters.

The data in figures 16 through 21 has been measured on samples of 20 μm diameter wire, respectively.

It can be derived from fig. 17 that the average grain sizes of the Pd-alloyed and annealed wires are similar to the grain sizes of the pure copper wires.

Fig. 19 shows that the Pd-alloyed wire has a slightly larger ball-bonding process window than the pure copper wire of the invention, with the windows being rather comparable.

Fig. 20 shows that in the case of second bond process windows, the Pd-alloyed samples of the invention exhibit a significantly larger window, both with respect to the ultrasonic energy as well as the force value.

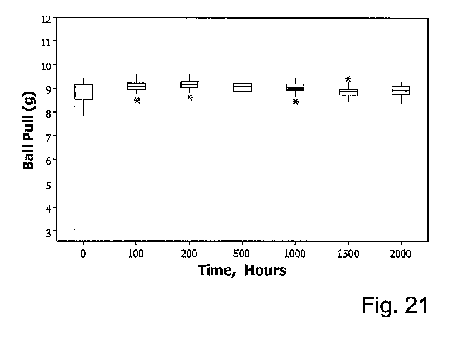

Fig. 21 shows a thermal aging behaviour at a temperature of 175°C for up to 2000 hours. No significant thermal aging at high temperature storage of the wire is visible on this time scale.

Generally, specific features of the respective embodiments can be combined with each other according to the respective demands. Further features, for example a coating of the wire core, can be added to any of the specific embodiments if suitable.

**Claims**

1. A bonding wire, comprising:

   a core (2) with a surface,
   wherein the core (2) comprises copper as a main component,
   wherein an average size of crystal grains in the core is between 2.5 μm and 30 μm, and
   wherein a yield strength of the bonding wire is less than 120 MPa.

2. Wire according to one of the preceding claims, wherein a Young's modulus of the wire is less than 100 GPa.

3. Wire according to one of the preceding claims, wherein a ratio between a diameter of the wire core (2) and the average grain size is between 2.5 and 6.

4.  Wire according to one of the preceding claims, wherein a total amount of copper of the wire core (2) is at least 97%.

5.  Wire according to one of the preceding claims, wherein the wire core contains palladium in an amount between 0.5 % and 3 %.

6.  Wire according to one of the preceding claims, wherein the wire core contains silver in an amount between 45 ppm and 900 ppm

7.  Wire according to one of the preceding claims, wherein the wire (1) has a diameter in the range of 8 $\mu$m to 80 $\mu$m.

8.  Wire according to one of the preceding claims, wherein the wire core has been annealed at a temperature of at least 580 °C for a time of at least 0.1 s prior to a bonding step.

9.  Wire according to one of the preceding claims, wherein an elongation value of the wire (1) after annealing is not more than 92% of a maximum elongation value.

10. Wire according to claim 9, wherein the wire (1) is annealed at a temperature which is at least 10°C higher than a temperature at which the maximum elongation value is achieved by annealing.

11. Wire according to one of the preceding claims, **characterized in that** a coating layer (3) is superimposed over the surface of the core (2).

12. Wire according to claim 11, wherein a mass of the coating layer is not more than 3 % of the mass of the wire core (2).

13. Wire according to claims 11 or 12, **characterized in that** the coating layer (3) comprises at least one of the group of Pd, Au, Pt and Ag as a main component.

14. Wire according to any of the preceding claims, wherein a hardness of the wire core (2) prior to bonding is not greater than 95.0 HV (0.010N/5s).

15. Wire according to one of the preceding claims, wherein a content of boron in the wire core is less than 100 ppm.

16. Wire according to one of the preceding claims, wherein
a diameter of the wire core is between 15 $\mu$m and 28 $\mu$m and the average grain size is between 2.5 $\mu$m and 6 $\mu$m; or
a diameter of the wire core is between 28 $\mu$m and 38 $\mu$m and the average grain size is between 3 $\mu$m and 10 um; or
a diameter of the wire core is between 38 $\mu$m and 50 $\mu$m and the average grain size is between 7 $\mu$m and 15 $\mu$m; or
a diameter of the wire core is between 50 $\mu$m and 80 $\mu$m and the average grain size is between 10 $\mu$m and 30 $\mu$m.

17. Module, comprising a first bond pad (11), a second bond pad (1) and a wire (1) according to any of the preceding claims, wherein the wire (1) is connected to one of the bond pads (11) by means of ball-bonding.

18. Module according to claim 17, wherein a process window area for the ball bond has a value of at least 120 g*mA in the case of bonding a wire of 20 $\mu$m diameter to an aluminium bond pad.

19. Method for manufacturing a bonding wire according to any of claims 1 to 16, comprising the steps of

    a. providing a copper core precursor with a demanded composition;
    b. drawing the precursor until a final diameter of the wire core is reached;
    c. annealing the drawn wire (1) at a defined temperature for a minimum annealing time.

20. Method according to claim 19, wherein the annealing is performed by strand annealing.

1

## Fig. 1

1

thickness of 3

L

15

2

3

diameter of 1

diameter of 2

23

## Fig. 2

| a. providing a wire core precursor | → | b. drawing the precursor to a final diameter |
| | | ↓ |
| | | c. annealing the wire at a defined temperature |
| | | ↓ |
| | | wire (1) |

Fig. 3

Fig. 4

Fig. 5

Fig. 6

Fig. 7

Fig. 8

Fig. 9

Fig. 10

Fig. 11

Fig. 12

Fig. 13a

Fig. 13b

Fig. 14

Fig. 15

EP 2 768 019 A2

Fig. 16

Fig. 17

Fig. 18

Fig. 19

Fig. 20

Fig. 21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7952028 B2